(19) Europäisches Patentamt
European Patent Office
Office européen des brevets

(11) **EP 4 715 403 A1**

(12) **EUROPEAN PATENT APPLICATION**

(43) Date of publication:
**25.03.2026 Bulletin 2026/13**

(21) Application number: **24200958.7**

(22) Date of filing: **18.09.2024**

(51) International Patent Classification (IPC):
**G01R 31/34** $^{(2020.01)}$

(52) Cooperative Patent Classification (CPC):
**G01R 31/34; G01R 31/343**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ABB SCHWEIZ AG**
**5400 Baden (CH)**

(72) Inventors:
• **RÖNNBERG, Kristian**
 **73191 Köping (SE)**

• **KAKOSIMOS, Panagiotis**
 **72358 Västerås (SE)**
• **PINTO, Cajetan**
 **28027 Madrid (ES)**
• **LUNDBERG, Simon**
 **72130 Västerås (SE)**
• **GULATI, Ankush**
 **248730 Singapore (SG)**

(74) Representative: **Kransell & Wennborg KB**
**P.O. Box 27834**
**115 93 Stockholm (SE)**

(54) **INVESTIGATING A MOTOR**

(57)     A method of investigating a motor comprises: obtaining (S100) name plate data of the motor, the name plate data comprising a nominal name plate efficiency ($\eta_{NP\_nom}$) of the motor or the nominal name plate efficiency ($\eta_{NP\_nom}$) of the motor being derivable from the name plate data, identifying (S102) the motor type based on the name plate data, checking (S104) if there exists measured efficiency data for the motor type, setting (S106), if measured efficiency data exists for the motor type, the measured efficiency data as investigating data for the motor, determining (S108) simulated efficiency data using a model (CM) of the motor and setting (S110) the simulated efficiency data as investigating data for the motor, if the measured efficiency data does not exist for the motor, where the nominal name plate efficiency ($\eta_{NP\_nom}$) is considered in the use of the model, and investigating (S112; S220) the motor using the investigating data.

Fig. 6

Description

## TECHNICAL FIELD

The technology disclosed herein relates generally to the field of motors, and in particular to an investigating device and a method, computer program and computer program product for investigating a motor.

## BACKGROUND

Loss estimation is an important aspect of energy saving analyses for motors.

Independently of if the input power or output power to the motor is measured or not, an accurate representation of the conversion efficiency is needed in order to estimate the losses.

A conventional approach is to define bespoke models, which however is both laborious and time consuming.

Another way of calculating the efficiency of a motor is to use name plate information in an equivalent circuit of the motor. This is for instance described in US 5661386.

However, there is still a need for improvement in the determining of efficiency for use in loss estimations. There is especially room for improvement of the speed and accuracy with which the efficiency can be determined.

## SUMMARY

The invention is concerned with the problem of improving the way that efficiency is determined when used in the investigating of a motor.

One object of the invention is therefore to improve the way that efficiency is determined when used in the investigating of a motor.

This object is according to a first aspect achieved by a method of investigating a motor comprising:

> obtaining name plate data of the motor, the name plate data comprising a nominal name plate efficiency of the motor or the nominal name plate efficiency of the motor being derivable from the name plate data,
> identifying the motor type based on the name plate data,
> checking if there exists measured efficiency data for the motor type,
> if measured efficiency data exists for the motor type, setting the measured efficiency data as investigating data for the motor,
> if the measured efficiency data does not exist for the motor, determining simulated efficiency data using a model of the motor, where the nominal name plate efficiency is considered in the use of the model, and setting the simulated efficiency data as investigating data for the motor, and
> investigating the motor using the investigating data.

The object is according to a second aspect achieved through an investigating device for investigating a motor, the investigating device comprising a processor operative to:

> obtain name plate data of the motor, the name plate data comprising a nominal name plate efficiency of the motor or the nominal name plate efficiency of the motor being derivable from the name plate data,
> identify the motor type based on the name plate data,
> check if there exists measured efficiency data for the motor type,
> if measured efficiency data exists for the motor type, set the measured efficiency data as investigating data for the motor,
> if the measured efficiency data does not exist for the motor, determine simulated efficiency data using a model of the motor, where the nominal name plate efficiency is considered in the use of the model, and set the simulated efficiency data as investigating data for the motor, and
> investigate the motor using the investigating data.

The object is according to a third aspect achieved through a computer program for investigating a motor, the computer program comprising computer program code which when run by a processor of an investigating device causes the investigating device to:

> obtain name plate data of the motor, the name plate data comprising a nominal name plate efficiency of the motor or the nominal name plate efficiency of the motor being derivable from the name plate data,
> identify the motor type based on the name plate data,

check if there exists measured efficiency data for the motor type,

if measured efficiency data exists for the motor type, set the measured efficiency data as investigating data for the motor,

if the measured efficiency data does not exist for the motor, determine simulated efficiency data using a model of the motor, where the nominal name plate efficiency is considered in the use of the model, and set the simulated efficiency data as investigating data for the motor, and

investigate the motor using the investigating data.

The object is according to a fourth aspect achieved through a computer program product for investigating a motor, the computer program product comprising a data carrier with the computer program according to the third aspect.

The measured efficiency data may comprise a range of efficiency measurement values. For a motor, the range of efficiency measurements may comprise efficiency measurements for different power levels as well as different torques and speeds.

If the measured efficiency data does not exist for the motor type, the method may further comprise investigating the nominal name plate efficiency of the motor and using it in the model when determining the simulated efficiency data if the investigating is successful.

If the measured efficiency data does not exist for the motor type, the investigating device may be further operative to investigate the nominal name plate efficiency of the motor and use it in the model when determining the simulated efficiency data if the investigating is successful.

The name plate data may comprise a rated name plate power.

If the measured efficiency data does not exist for the motor type and the name plate data comprises the rated name plate power, the method may further comprise calculating a nominal classification standard efficiency of the motor using the rated name plate power in an equation defined by a motor classification standard. The investigating of the nominal name plate efficiency of the motor may in this case comprise comparing the nominal name plate efficiency with the nominal classification standard efficiency, using the nominal name plate efficiency in the model if the comparison is successful and using the nominal classification standard efficiency in the model if the comparison is not successful.

If the measured efficiency data does not exist for the motor type and the name plate data comprises the rated name plate power, the investigating device may be further operative to calculate a nominal classification standard efficiency of the motor using the rated name plate power in an equation defined by a motor classification standard. The investigating of the nominal name plate efficiency of the motor may in this case comprise comparing the nominal name plate efficiency with the nominal classification standard efficiency, using the nominal name plate efficiency in the model if the comparison is successful and using the nominal classification standard efficiency in the model if the comparison is not successful.

The model may be an equivalent circuit model of the motor.

The use of a nominal efficiency in the model may comprise adapting the model parameters using the nominal efficiency. The determining of simulated efficiency data may comprise evaluating the equivalent circuit with the adapted model parameters for different power levels, different torques and speeds of the motor.

The name plate data may additionally comprise a rated name plate current and a rated name plate power factor.

If the measured efficiency data does not exist for the motor and the name plate data comprises the rated name plate current and the rated name plate power factor, then the method may further comprise determining a classification standard power factor based on the nominal classification standard efficiency, the rated name plate power and a present current, which present current, at least initially, is the rated name plate current, using the rated name plate power factor with the nominal name plate efficiency in the model if the comparison is successful, and using the classification standard power factor together with the nominal classification standard efficiency in the model if the comparison is not successful.

If the measured efficiency data does not exist for the motor and the name plate data comprises the rated name plate current and the rated name plate power factor, then the investigating device may be further operative to determine a classification standard power factor based on the nominal classification standard efficiency, the rated name plate power and a present current, which present current, at least initially, is the rated name plate current, use the rated name plate power factor with the nominal name plate efficiency in the model if the comparison is successful, and use the classification standard power factor together with the nominal classification standard efficiency in the model if the comparison is not successful.

Likewise, a name plate power factor may be determined based on the nominal name plate efficiency, the rated name plate power and the rated name plate current,

The name plate data may also comprise a rated name plate voltage. In this case the classification scheme power factor and possibly also the name plate power factor may be determined also based on the rated name plate voltage.

As can be seen above, the present current used for determining the classification standard power factor may initially be the rated name plate current.

In this case, the method may further comprise comparing the classification standard power factor with a power factor threshold, using the classification standard power factor in the model if it is below the power factor threshold and otherwise incrementing the present current and determining the classification standard power factor based on the nominal classification standard efficiency, the rated name plate power and the present current until the classification standard power factor falls below the power factor threshold.

In this case, the investigating device may be further operative to compare the classification standard power factor with a power factor threshold, use the classification standard power factor in the model if it is below the power factor threshold and otherwise increment the present current and determine the classification standard power factor based on the nominal classification standard efficiency, the rated name plate power and the present current until the classification standard power factor falls below the power factor threshold.

The investigating of the motor may comprise applying the investigating data in a power conversion loss function for the motor, where it is additionally possible that the power conversion loss function defines an instantaneous power conversion loss of the motor.

The identifying may comprise identifying the motor type and size based on the name plate data, the checking may comprise checking if there exists measured efficiency data for the motor type and size, and a setting of measured efficiency data as investigating data for the motor may be made if measured efficiency data exists for the motor type and size.

The checking if there exists measured efficiency data may additionally comprise searching for the data in a motor database.

Generally, all terms used in the claims are to be interpreted according to their ordinary meaning in the technical field, unless explicitly defined otherwise herein. All references to "a/an/the element, apparatus, component, means, module, action, etc." are to be interpreted openly as referring to at least one instance of the element, apparatus, component, means, module, action, etc., unless explicitly stated otherwise. The actions of any method disclosed herein do not have to be performed in the exact order disclosed, unless explicitly stated.

## BRIEF DESCRIPTION OF THE DRAWINGS

The inventive concept is now described, by way of example, with reference to the accompanying drawings.

Fig. 1 is a diagram showing a motor connected to a motor drive, where the motor also drives a load.

Fig. 2 schematically shows an investigating device connected to a motor database with efficiency data about different types of motors,

Fig. 3 schematically shows one realization of the investigating device, which investigating device is realized as a processor acting on computer instructions in a memory,

Fig. 4 schematically shows a computer program product with computer instructions for realizing motor investigating functionality of the investigating device,

Fig. 5 shows some exemplifying columns with data in the motor database,

Fig. 6 shows a flow chart of a first embodiment of a method for investigating a motor,

Fig. 7 shows a flow chart of a second embodiment of a method for investigating a motor, and

Fig. 8 shows a flow chart of a number of further method steps that can be used in the second embodiment.

## DETAILED DESCRIPTION

The inventive concept will now be described more fully hereinafter with reference to the accompanying drawings, in which certain embodiments of the inventive concept are shown. This inventive concept may, however, be embodied in many different forms and should not be construed as limited to the embodiments set forth herein; rather, these embodiments are provided by way of example so that this disclosure will be thorough and complete, and will fully convey the scope of the inventive concept to those skilled in the art. Like numbers refer to like elements throughout the description.

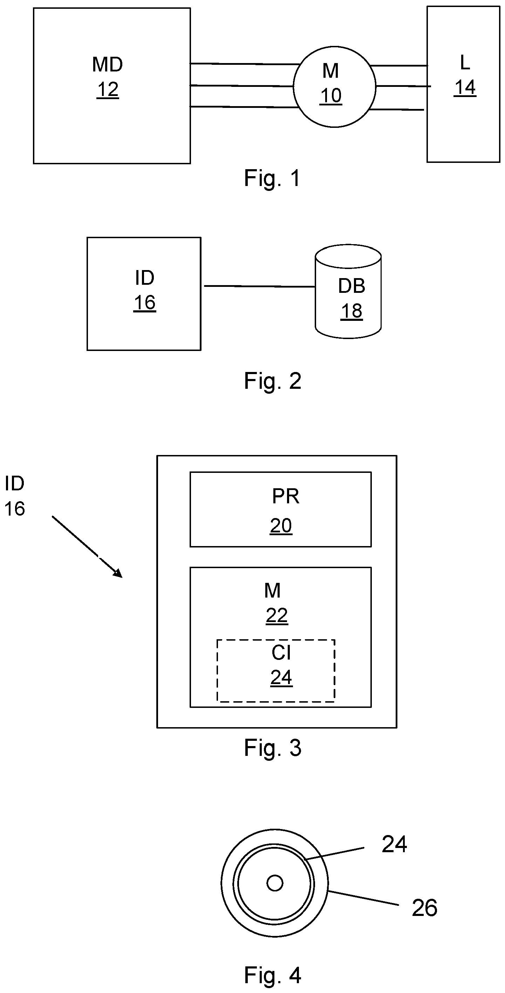

Fig. 1 schematically shows one example of a motor 10 for which investigations are to be performed, which investigations may involve estimating power conversion losses of the motor 10. The motor 10 may drive a load LD 14 and may also be connected to a motor drive MD 12.

Fig. 2 schematically shows an investigating device ID 16 for performing the above-mentioned investigations. The investigating device 16 is also connected to a motor database DB 18 comprising efficiency data of different motors.

Fig. 3 schematically shows one realization of the investigating device ID 16. The investigating device 16 may be realized as a processor PR 20 with associated program memory M 22 including a computer program with computer program code or computer program instructions CI 24 for implementing motor investigating functionality of the investigating device 16.

A computer program may also be provided via a computer program product, for instance in the form of a non-transitory computer readable storage medium or data carrier, like a CD ROM, a memory stick or memory card, carrying such a computer program with the computer program code or computer program instructions, which will implement the motor investigating functionality when being loaded into a processor. One such computer program product in the form of a CD ROM 26 with the above-mentioned computer program comprising computer program instructions 24 is schematically shown in fig. 4.

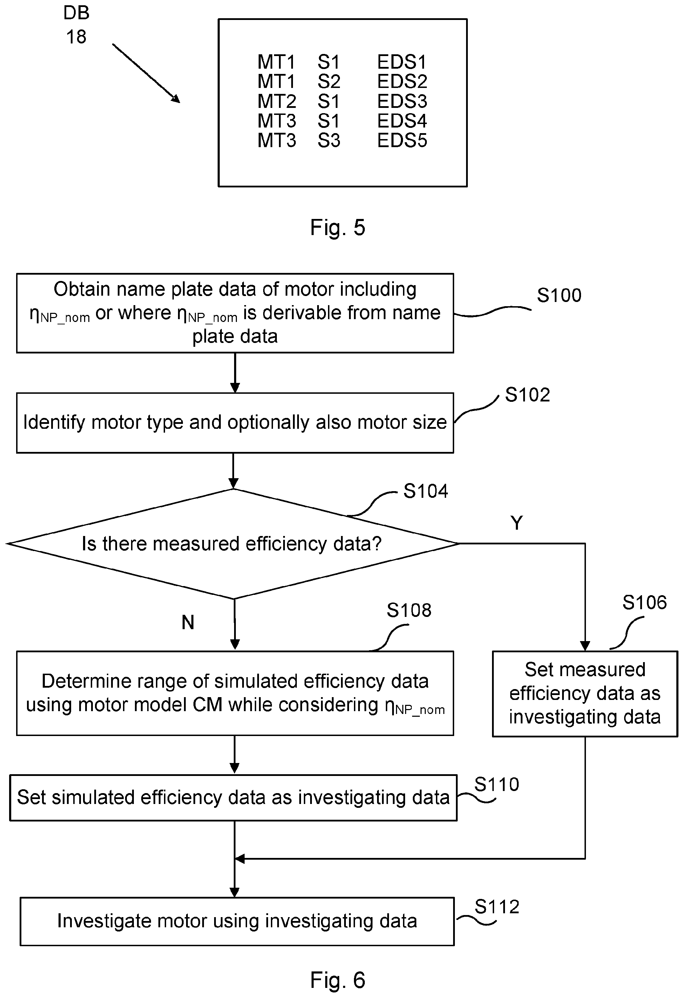

Fig. 5 schematically shows an example of the content of the motor database DB 18. As was mentioned above, the motor database 18 comprises efficiency data about different types of motors. It may more particularly comprise data about measured efficiencies for different types of motors and optionally also different types of motor sizes. There may therefore be a range of efficiency measurement values for each motor type and optionally also for one or more motor sizes, where a range may correspond to an efficiency curve defining an efficiency that depends on a power of the motor, such as the output or input power. There may additionally be a number of efficiency curves for different power levels, torques and speeds for each motor type and optionally also for one or more motor sizes. Therefore, the motor database 18 may comprise a number of columns, such as a first column where a motor type is defined, another column with efficiency data obtained via measurements made on the motors and optionally also a column with motor size of the different types of motors. As an example, the motor database 18 comprises a first efficiency data set EDS1 with measured efficiency data concerning a first type of motor MT1 of a first size S1, a second efficiency data set EDS2 with measured efficiency data concerning a second size S2 of the first type of motor MT1, a third efficiency data set EDS3 with measured efficiency data concerning a second type of motor MT2 of a first size S1, a fourth efficiency data set EDS4 with measured efficiency data concerning a third type of motor MT3 of the first size S1 and a fifth efficiency data set EDS5 with measured efficiency data concerning the third type of motor MT3 of a third size S3. Each efficiency data set may comprise a range of efficiency measurements being made at different power levels. The motor database 18 may thus comprise measured efficiencies of different motors and sizes.

As was indicated above, aspects of the invention are concerned with energy saving analyses, which energy saving analyses may involve performing energy saving potential estimations. In performing energy saving potential estimations of installed motors, it may be necessary to find an as accurate as possible way to estimate the losses in the power conversion process of the motor.

The investigating of the motor may comprise applying the investigating data in a power conversion loss function for the motor, where it is additionally possible that the power conversion loss function defines an instantaneous power conversion loss of the motor.

A power conversion loss function that defines an instantaneous power conversion loss of the motor can be represented by

$$P_{loss}(t) = \frac{P_{out}(t)}{\eta} - P_{out}(t) \tag{1}$$

where $P_{loss}$ is power loss in the motor, $P_{out}$ is output power from the motor, t is time and $\eta$ is the efficiency of the motor.

The accuracy in the estimation is very dependent on how well $\eta$ represents the motor under consideration.

Aspects of the present disclosure are concerned with providing a fast determining of accurate efficiencies.

How this can be done according to a first embodiment will now be described with reference also being made to fig. 6, which shows a flow chart of steps in a method for investigating a motor.

The motor 10 in fig. 1 may be a motor that is to be investigated, for instance with regard to potential energy savings.

The operation may be started through the motor investigating functionality of the investigating device 16 obtaining name plate data of the motor 10, S100,

Name plate data may be obtained through optical scanning of a physical name plate, identifying symbols using OCR recognition and deducing the name plate data from the identified symbols. The name plate data may also be obtained through reading a bar or QR (Quick-Response) code or an NFC (Near-Field Communication) tag. It may also be obtained through a user reading a name plate and manually entering the name plate data into the investigating device 16. It is also possible that the name plate data is provided in digital format that is accessible for the investigating device. The name plate data may be provided on a server or in a database, to which the investigating device 16 has access and from where it can download or in which it can locate the name plate data.

The name plate data typically comprises a motor type identifier MTI, a rated name plate current $I_{R\_NP}$, a rated name plate voltage $V_{R\_NP}$, a rated name plate power $P_{R\_NP}$ and a rated name plate power factor $\cos(\varphi_{R\_NP})$. Optionally the name plate data also comprises a nominal efficiency $\eta_{NP\_nom}$ and data about the size of the motor.

Thus, the name plate data may comprise a nominal name plate efficiency $\eta_{NP\_nom}$ of the motor 10. Alternatively, the nominal name plate efficiency $\eta_{NP\_nom}$ may be derivable from the name plate data.

As will be shown later, the nominal name plate efficiency $\eta_{NP\_nom}$ will be used. It may thus be important to know.

If the name plate data comprises the nominal name plate efficiency $\eta_{NP\_nom}$, then this nominal efficiency can be directly used. However, if the name plate data does not include the nominal name plate efficiency $\eta_{NP\_nom}$, then it may be derived from the name plate data, such as from the rated name plate power $P_{R\_NP}$, the rated name plate current $I_{R\_NP}$, the rated name plate voltage $V_{R\_NP}$ and the rated name plate power factor $\cos(\varphi_{R\_NP})$.

As an example, the nominal name plate efficiency $\eta_{NP\_nom}$ may be obtained as:

$$\eta_{NP,nom} = \frac{P_{R\_NP}}{\sqrt{3} \times V_{R\_NP} \times I_{R\_NP} \times \cos \varphi_{R\_NP}} \qquad (2)$$

After the name plate data has been obtained, the investigation functionality of the investigation device identifies the motor type and optionally also the motor size based on the name plate data, S102, i.e. based on the motor type identifier MTI and size data.

The motor investigation functionality of the investigating device 16 checks in the motor database 18 if there exists measured efficiency data for the motor type. The checking if there exists measured efficiency data may thus comprise searching for the data in the motor database 18.

For instance, if the motor 10 is of the second type MT2, then it is possible to identify and use the third set of measured efficiency data EDS3 for the motor type. It is additionally possible that the motor is of a certain size. If for instance the motor 10 is of the first type MT1 and the first size S1, it is possible to identify and use the first efficiency data set EDS1 for the motor 10.

Thus, the identifying may comprise identifying the motor type and size based on the name plate data and the checking may comprise checking if there exists measured efficiency data for the motor type and size. A setting of measured efficiency data as investigating data for the motor may then be made if measured efficiency data exists for the motor type and size.

Thus, if there is an efficiency data set with measured efficiency data for the motor type and possibly also for the motor size in the motor database 18, S104, then this measured efficiency data is selected as or set to be investigating data for the motor, S106.

However, if there is no measured efficiency data for the motor type or motor size, S104, then the motor investigation functionality of the investigating device 16 determines simulated efficiency data using a model of the motor 10, where the nominal name plate efficiency $\eta_{NP\_nom}$ is considered in the use of the model, S108.

The considering of the nominal name plate efficiency $\eta_{NP\_nom}$ in the use of the model may involve applying the nominal name plate efficiency $\eta_{NP\_nom}$ in the model CM. The considering of the nominal name plate efficiency $\eta_{NP\_nom}$ may thus comprise investigating the nominal name plate efficiency $\eta_{NP\_nom}$ and using it in the model CM when determining the simulated efficiency data if the investigating is successful. The investigating may involve comparing the nominal name plate efficiency $\eta_{NP\_nom}$ with a nominal classification standard efficiency $\eta_{CS\_nom}$ and using either the nominal name plate efficiency $\eta_{NP\_nom}$ or the nominal classification standard efficiency $\eta_{CS\_nom}$ in the motor model based on the comparison. The investigating of the nominal name plate efficiency $\eta_{NP\_nom}$ of the motor may comprise comparing the nominal name plate efficiency $\eta_{NP\_nom}$ with the nominal classification standard efficiency $\eta_{CS\_nom}$ and using the nominal name plate efficiency $\eta_{NP\_nom}$ in the model CM if the comparison is successful. The motor classification standard may be the IEC 60034-30-1 classification standard.

The model may be an automatically generated machine equivalent circuit model CM, which describes the efficiency $\eta$ of the motor 10 under consideration. The model may thus be based on an equivalent circuit of the motor, such as a circuit of different inductances of the rotor and stator of the motor. The model may also comprise leakage inductances, leakage capacitances and leakage resistances.

The selected nominal efficiency may then be used in the motor model in order to obtain or determine a range of simulated efficiency data, which range of simulated efficiency data is then set as investigating data, S110.

The use of a nominal efficiency in the model may comprise adapting the model parameters using the nominal efficiency. The determining of simulated efficiency data may comprise evaluating the equivalent circuit with the adapted model parameters for different power levels, different torques and speeds of the motor.

The range of efficiency data may comprise a range of simulated efficiencies for different power levels. The efficiency may be determined as a function of the power, such as a function of the output power, for instance as an efficiency curve.

In this manner accurate efficiencies are obtained in a fast way.

The motor is thereafter investigated using the investigating data, S112, for instance using equation (1) above.

Thus, the investigating of the motor may comprise applying the investigating data in a power conversion loss function for the motor 10, where it is additionally possible that the power conversion loss function defines an instantaneous power conversion loss of the motor 10.

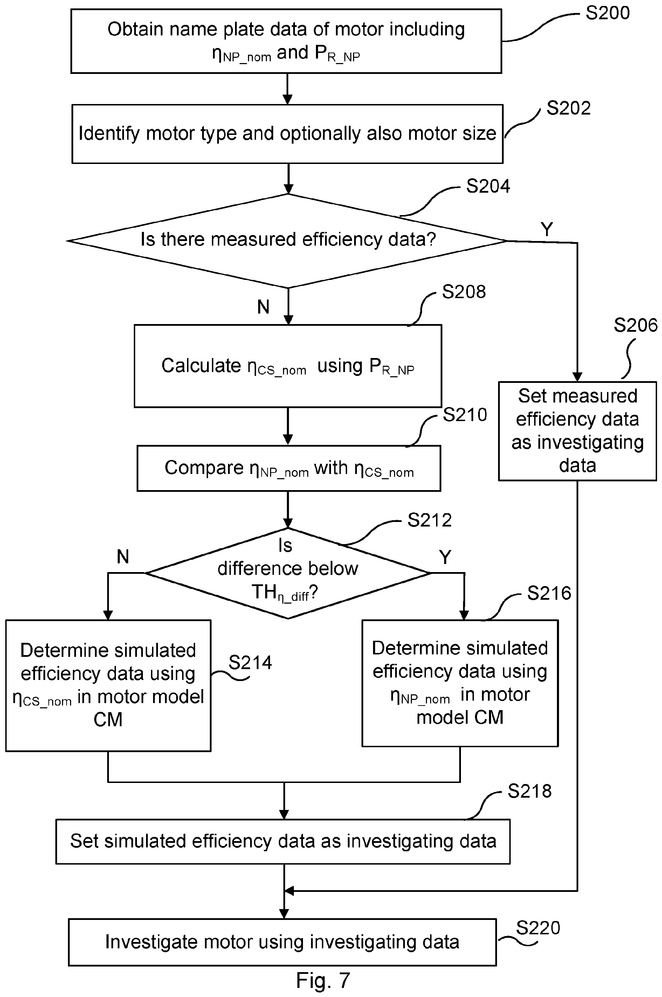

Now a second embodiment will be described with reference being made to the flow chart in fig. 7.

The operation may again be started through the motor investigating functionality of the investigating device 16 obtaining name plate data of the motor 10 that is to be investigated, S200. In this case the name plate data comprises the nominal efficiency $\eta_{NP\_nom}$ of the motor. However, it should be realized that also here it is possible that the nominal name plate efficiency $\eta_{NP\_nom}$ is derived from the name plate data in the way described in the first embodiment. Here, the name plate data also comprises the rated name plate power $P_{R\_NP}$, as well as a motor type identifier MTI and possibly also data about the motor size and information of an efficiency class according to a motor classification standard. Name plate data may be obtained in any of the previously described ways.

After the name plate data has been obtained, the motor investigation functionality of the investigating device 16 identifies the motor type and optionally also the motor size based on the name plate data, S202. Thereafter, the motor investigation functionality of the investigating device 16 checks in the motor database 18 if there exists measured efficiency data for the motor type.

If there exists an efficiency data set with measured efficiency data for the motor type and perhaps also for the motor size, S204, then the measured efficiency data in the efficiency data set is selected as or set to be investigating data for the motor, S206.

However, if there is no measured efficiency data for the motor type or motor size, S204, i.e. if the measured efficiency data does not exist for the motor type or motor size, then the motor investigation functionality of the investigating device 16 determines simulated efficiency data using a model of the motor, where the nominal name plate efficiency $\eta_{NP\_nom}$ is considered in the use of the model.

In this embodiment the determining of the simulated efficiency data using a model of the motor while considering the nominal name plate efficiency $\eta_{NP\_nom}$, involves investigating the nominal name plate efficiency and using it in the model when determining the simulated efficiency data if the investigating is successful. The investigating of the nominal name plate efficiency may comprise a number of steps.

First of all a nominal classification standard efficiency $\eta_{CS\_nom}$ may be calculated using the rated name plate power $P_{R\_NP}$, S208. The nominal classification standard efficiency $\eta_{CS\_nom}$ may additionally be calculated using the rated name plate power $P_{R\_NP}$ in an equation defined by a motor classification standard.

If the motor classification standard is IEC 60034-30-1, then the efficiency maybe calculated from a corresponding IE-class or efficiency class as:

$$\eta_{CS\_nom} = A \times (\log P_R)^3 + B \times (\log P_R)^2 + C \times \log P_R + D \tag{3}$$

where A, B, C, D are coefficients of the IE-class from the IEC 60034-30-1 standard. If no class is available, then the class IE2 may be assumed.

The investigating of the nominal name plate efficiency $\eta_{NP\_nom}$ of the motor may comprise comparing the nominal name plate efficiency $\eta_{NP\_nom}$ with the nominal classification standard efficiency $\eta_{CS\_nom}$ and using the nominal name plate efficiency $\eta_{NP\_nom}$ in the model CM if the comparison is successful.

Thus, the nominal name plate efficiency $\eta_{NP\_nom}$ is compared with the nominal classification scheme efficiency $\eta_{CS\_nom}$, S210. The comparison may more particularly involve comparing the difference or an absolute value of a difference between the nominal classification scheme efficiency $\eta_{CS\_nom}$ and the nominal name plate efficiency $\eta_{NP\_nom}$ with a maximum difference threshold $TH_{\eta\_diff}$, where $TH_{\eta\_diff}$ may as an example be 0.05 This could be expressed as:

$$\left| \eta_{CS\_nom,} - \eta_{NP\_nom} \right| < TH_{\eta\_diff} \tag{4}$$

If the difference or the absolute value of the difference is below the maximum difference threshold, S212, then simulated efficiency data is determined using the nominal name plate efficiency $\eta_{NP\_nom}$ in the motor model CM, S216.

Thus, the comparison is successful if a difference or an absolute value of a difference between the nominal name plate efficiency $\eta_{NP\_nom}$ and the nominal classification standard efficiency $\eta_{CS\_nom}$ is below the maximum difference threshold $TH_{\eta\_diff}$.

In case the difference or the absolute value of the difference is not below the maximum difference threshold $TH_{\eta\_diff}$, S212, i.e. if the difference or the absolute value of the difference is above or equal to the maximum difference threshold $TH_{\eta\_diff}$, then simulated efficiency data is determined using the nominal classification scheme efficiency $\eta_{CS\_nom}$, S214.

The use of efficiency in the circuit model CM may be made in the same way as in the first embodiment in order to obtain a range of efficiency values.

In this manner accurate efficiencies are obtained in a fast way, where additionally classification standard efficiencies are used instead of name plate efficiencies, if the name plate efficiencies are deemed unreliable. This may improve the accuracy of the range of efficiencies even further.

Thereafter, the determined simulated efficiency data is set as investigating data for the motor, S218, which is followed by investigating the motor using the investigating data, S220, which investigating may be performed in the previously described way using equation (1).

The determining of the simulated efficiency data may involve using the power factor cosφ.

If the name plate data includes a rated name plate power factor $\cos(\varphi_{R\_NP})$ it may be used together with the nominal name plate efficiency $\eta_{NP\_nom}$ in the determining of simulated efficiency data in step 216. Alternatively, the rated name plate power factor $\cos(\varphi_{R\_NP})$ may be determined using the following equation:

$$\cos(\varphi_{R\_NP}) = \frac{P_{R\_NP}}{\sqrt{3} \times V_{R\_NP} \times I_{P\_NP} \times \eta_{NP\_nom}} \tag{5}$$

Thus, the rated name plate power factor $\cos(\varphi_{R\_NP})$ may be determined based on the nominal name plate efficiency $\eta_{NP\_nom}$, the rated name plate power $P_{R\_NP}$, the rated name plate voltage $V_{R\_NP}$ and the rated name plate current $I_{R\_NP}$. A classification standard power factor $\cos(\varphi_{R\_NP})$ may similarly be used together with the nominal classification standard efficiency $\eta_{CS\_nom}$ in the determining of simulated efficiency data in step S214. The classification standard power factor $\cos(\varphi_{R\_NP})$ may be determined in a similar way using equation (5), but where the nominal classification standard efficiency $\eta_{CS\_nom}$ replaces the nominal name plate efficiency $\eta_{NP\_nom}$.

Thus, if the measured efficiency data does not exist for the motor, then a classification standard power factor $\cos(\varphi_{R\_NP})$ may be determined based on the nominal classification standard efficiency $\eta_{CS\_nom}$, the rated name plate power $P_{R\_NP}$, the rated name plate voltage $V_{R\_NP}$ and the rated name plate current $I_{R\_NP}$. The rated name plate power factor $\cos(\varphi_{R\_NP})$ is then used with the nominal name plate efficiency $\eta_{NP\_nom}$ in the model if the comparison is successful and the classification standard power factor cos(cpcs) is used together with the nominal classification standard efficiency $\eta_{CS\_nom}$ in the model if the comparison is not successful.

Alternatively, it is possible that an adjusted classification standard power factor is used in step 214.

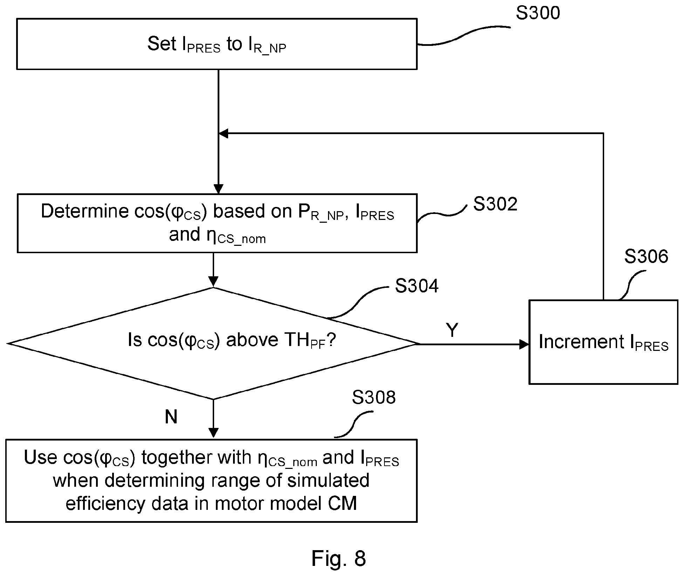

How the power factor can be adjusted will now be described with reference being made to the further method steps shown in fig. 8.

The operation may start by setting a present current $I_{PRES}$. The present current $I_{PRES}$ may initially be set to the rated name plate current $I_{R\_NP}$, S300.

A tentative classification scheme power factor cos(cpcs) is then determined based on the rated name plate power $P_{R\_NP}$, the present current $I_{PRES}$, the nominal classification scheme efficiency $\eta_{CS\_nom}$ and possibly also the rated name plate voltage $V_{R\_NP}$, S302.

As an example, the determination can be carried out according to equation (6) below:

$$\cos(\varphi_{CS}) = \frac{P_{R\_NP}}{\sqrt{3} \times V_{R\_NP} \times I_{PRES} \times \eta_{CS\_nom}} \tag{6}$$

Thereafter, the tentative classification scheme power factor is compared with a power factor threshold $TH_{PF}$.

If the tentative power factor $\cos(\varphi_{CS})$ is above the power factor threshold $TH_{PF}$, S304, then the present current $I_{PRES}$ is incremented, S306, which incrementing may involve increasing the value of the present current with a fixed step size.

As an example, the power factor threshold $TH_{PF}$ may be 0.9 and the step size may be 0.5 A.

After having incremented the present current $I_{PRES}$, it is again used in determining the tentative power factor, S302.

The operation continues in this loop until the tentative power factor cos(cpcs) is equal to or below the power factor threshold $TH_{PF}$, in which case the tentative power factor cos(cpcs) and present current $I_{PRES}$ get fixed and used as the classification standard power factor and classification standard current in the determination of the range of simulated efficiency data, S308.

Thus, the classification standard power factor cos(cpcs) is compared with a power factor threshold $TH_{PF}$, and the classification standard power factor cos(cpcs) is used in the model if it is below the power factor threshold $TH_{PF}$ and otherwise the present current is incremented, S306, the classification standard power factor cos(cpcs) determined based on the nominal classification standard efficiency $\eta_{CS\_nom}$, the rated name plate power $P_{R\_NP}$ and the present current $I_{PRES}$; S302, until the classification standard power factor cos(cpcs) falls below the power factor threshold $TH_{PF}$, S304.

Thereby a classification standard power factor is adjusted if it is found to be unreliable, which improves the accuracy of the range of efficiencies even further.

Put differently, aspects described herein provide:

1) name plate data for the motor under consideration, for instance in a name plate database,

2) a motor database with efficiency measurements from manufactured machines,

3) an algorithm to generate an equivalent circuit model representing a motor that is used in a function to estimate the conversion efficiency, and

4) an automatic selection process for choosing if a model based on measurements or a model based on an equivalent circuit is to be used,

The name plate data may be entered into a name plate database for later retrieval by as numbers. The name plate data may then later be used to search a motor database with efficiency measurements of manufactured machines, or to generate an equivalent circuit model based on a set of decision rules. This automatically selected method represents $\eta$ in the computations. This approach speeds up the process of energy savings analysis significantly as the development of bespoke models to represent $\eta$ is substituted for a search-and-select approach. In addition to speeding up the process, it also opens up for continuous improvements as the motor database of efficiency measurements can be populated with more information continuously. The model generation is also possible to continuously improve.

The inventive concept has mainly been described above with reference to a few embodiments. However, as is readily appreciated by a person skilled in the art, other embodiments than the ones disclosed above are equally possible within the scope of the inventive concept, as defined by the appended patent claims.

**Claims**

1. A method of investigating a motor (10) comprising:

   obtaining (S100; S200) name plate data of the motor, said name plate data comprising a nominal name plate efficiency ($\eta_{NP\_nom}$) of the motor or the nominal name plate efficiency ($\eta_{NP\_nom}$) of the motor being derivable from the name plate data,
   identifying (S102; S202) the motor type (MT1) based on the name plate data,
   checking (S104; S204) if there exists measured efficiency data (EDS1; EDS3) for the motor type (MT1; MT2),
   if measured efficiency data (EDS1; EDS3) exists for the motor type (MT1; MT2), setting (S106; S206) the measured efficiency data (EDS1; EDS3) as investigating data for the motor,
   if the measured efficiency data does not exist for the motor,

      determining (S108; S208 - S216) simulated efficiency data using a model (CM) of the motor, where the nominal name plate efficiency ($\eta_{NP\_nom}$) is considered in the use of the model, and
      setting (S110; S218) the simulated efficiency data as investigating data for the motor, and

   investigating (S112; S220) the motor using the investigating data.

2. The method according to claim 1, further comprising investigating, if the measured efficiency data does not exist for the motor type, the nominal name plate efficiency ($\eta_{NP\_nom}$) of the motor, and using it (S216) in the model (CM) when determining the simulated efficiency data if the investigating is successful.

3. The method according to claim 2, further comprising calculating (S208), if the measured efficiency data does not exist for the motor type and the name plate data comprises a rated name plate power ($P_{R\_NM}$), a nominal classification standard efficiency ($\eta_{CS\_nom}$) of the motor using the rated name plate power ($P_{R\_NM}$) in an equation defined by a motor classification standard (CS), wherein the investigating of the nominal name plate efficiency ($\eta_{NP\_nom}$) of the motor comprises comparing (S210) the nominal name plate efficiency ($\eta_{NP\_nom}$) with the nominal classification standard efficiency ($\eta_{CS\_nom}$), using (S216) the nominal name plate efficiency ($\eta_{NP\_nom}$) in the model (CM) if the comparison is successful, and using (S214) the nominal classification standard efficiency ($\eta_{CS\_nom}$) in the model if the comparison is not successful.

4. The method according to claim 3, wherein the comparison is successful if a difference between the nominal name plate efficiency ($\eta_{NP\_nom}$) and the nominal classification standard efficiency ($\eta_{CS\_nom}$) (S212) is below a maximum difference threshold ($TH_{\eta\_diff}$).

5. The method according to claim 3 or 4, further comprising determining (S302), if the measured efficiency data does not exist for the motor and the name plate data comprises a rated name plate current ($I_{R\_NP}$) and a rated name plate power

factor $(\cos(\varphi_{R\_NP}))$, a classification standard power factor $(\cos(cpcs))$ based on the nominal classification standard efficiency $(\eta_{CS\_nom})$, the rated name plate power $(P_{R\_NM})$ and a present current $(I_{PRES})$, which present current, at least initially, is the rated name plate current $(I_{R\_NP})$, using the rated name plate power factor $(\cos(\varphi_{R\_NP}))$ with the nominal name plate efficiency $(\eta_{NP\_nom})$ in the model if the comparison is successful, and using the classification standard power factor $(\cos(cpcs))$ together with the nominal classification standard efficiency $(\eta_{CS\_nom})$ in the model if the comparison is not successful.

6. The method according to claim 5, further comprising comparing (S304) the classification standard power factor $(\cos(cpcs))$ with a power factor threshold $(TH_{PF})$, using (S308) the classification standard power factor $(\cos(cpcs))$ in the model if it is below the power factor threshold $(TH_{PF})$, and otherwise incrementing (S306) the present current $(I_{PRES})$ and determining (S302) the classification standard power factor $(\cos(cpcs))$ based on the nominal classification standard efficiency $(\eta_{CS\_nom})$, the rated name plate power $(P_{R\_NP})$ and the present current $(I_{PRES})$ until the classification standard power factor $(\cos(cpcs))$ falls below the power factor threshold $(TH_{PF})$, wherein the present current used for determining (S302) the classification standard power factor $(\cos(cpcs))$ initially is the rated name plate current $(I_{R\_NP})$.

7. The method according to any previous claim, wherein the investigating (S112; S220) of the motor (10) comprises applying the investigating data in a power conversion loss function for the motor (10).

8. The method according to any previous claim, wherein the model (CM) is an equivalent circuit model of the motor (10).

9. The method according to any previous claim, wherein the identifying (S102; S202) comprises identifying the motor type and size based on the name plate data, the checking (S104; S204) if there exists measured efficiency data comprises checking if there exists measured efficiency data for the motor type (MT1) and size (S1), and a setting (S106; S206) of measured efficiency data (EDS1) as investigating data for the motor is made if measured efficiency data (EDS1) exists for the motor type (MT1) and size (S1).

10. The method according to any previous claim, wherein the checking (S104; S204) if there exists measured efficiency data comprises searching for the data in a motor database (18).

11. An investigating device (16) for investigating a motor (10), the investigating device (16) comprising a processor (20) operative to:

obtain name plate data of the motor, said name plate data comprising a nominal name plate efficiency $(\eta_{NP\_nom})$ of the motor or the nominal name plate efficiency $(\eta_{NP\_nom})$ of the motor being derivable from the name plate data, identify the motor type (MT1; MT2) based on the name plate data, check if there exists measured efficiency data (EDS1; EDS3) for the motor type (MT1; MT2), if measured efficiency data (EDS1; EDS3) exists for the motor type (MT1; MT2), set the measured efficiency data (EDS1; EDS3) as investigating data for the motor, if the measured efficiency data does not exist for the motor,

determine simulated efficiency data using a model (CM) of the motor, where the nominal name plate efficiency $(\eta_{NP\_nom})$ is considered in the use of the model, and set the simulated efficiency data as investigating data for the motor, and investigate (S112; S220) the motor using the investigating data.

12. The investigating device (16) according to claim 11, wherein the processor is further operative to investigate, if the measured efficiency data does not exist for the motor type, the nominal name plate efficiency $(\eta_{NP\_nom})$ of the motor and use it (S216) in the model (CM) when determining the simulated efficiency data if the investigating is successful.

13. The investigating device (16) according to claim 12, wherein the processor (29) is further operative to calculate, if the measured efficiency data does not exist for the motor type and the name plate data comprises a rated power $(P_{R\_NP})$, a nominal classification standard efficiency $(\eta_{CS\_nom})$ of the motor using the rated power $(P_{R\_NP})$ in an equation defined by a motor classification standard (CS), wherein the investigating of the nominal name plate efficiency $(\eta_{NP\_nom})$ of the motor comprises comparing the nominal name plate efficiency $(\eta_{NP\_nom})$ with the nominal classification standard efficiency $(\eta_{CS\_nom})$, and the determining of simulated efficiency data using a model (CM) of the motor comprises using the nominal name plate efficiency $(\eta_{NP\_nom})$ in the model (CM) if the comparison is successful, and using the nominal classification standard efficiency $(\eta_{CS\_nom})$ in the model if the comparison is not successful.

14. A computer program for investigating a motor, the computer program comprising computer program code (24) which when run by a processor (20) of an investigating device (16) causes the investigating device (16) to:

obtain name plate data of the motor, said name plate data comprising a nominal name plate efficiency ($\eta_{NP\_nom}$) of the motor or the nominal name plate efficiency ($\eta_{NP\_nom}$) of the motor being derivable from the name plate data, identify the motor type (MT1; MT2) based on the name plate data, check if there exists measured efficiency data (EDS1; EDS3) for the motor type (MT1; MT2), if measured efficiency data (EDS1; EDS3) exists for the motor type (MT1; MT3), set the measured efficiency data (EDS1) as investigating data for the motor, if the measured efficiency data does not exist for the motor,

determine simulated efficiency data using a model (CM) of the motor, where the nominal name plate efficiency ($\eta_{NP\_nom}$) is considered in the use of the model, and set the simulated efficiency data as investigating data for the motor, and investigate (S112; S220) the motor using the investigating data.

15. A computer program product for investigating a motor, the computer program product comprising a data carrier (26) with the computer program code (24) according to claim 14.

Fig. 1

Fig. 2

Fig. 3

Fig. 4

DB
18

MT1    S1    EDS1
MT1    S2    EDS2
MT2    S1    EDS3
MT3    S1    EDS4
MT3    S3    EDS5

Fig. 5

Obtain name plate data of motor including $\eta_{NP\_nom}$ or where $\eta_{NP\_nom}$ is derivable from name plate data    S100

Identify motor type and optionally also motor size    S102

Is there measured efficiency data?    S104

Y

N

Determine range of simulated efficiency data using motor model CM while considering $\eta_{NP\_nom}$    S108

Set measured efficiency data as investigating data    S106

Set simulated efficiency data as investigating data    S110

Investigate motor using investigating data    S112

Fig. 6

Obtain name plate data of motor including $\eta_{NP\_nom}$ and $P_{R\_NP}$ — S200

Identify motor type and optionally also motor size — S202

Is there measured efficiency data? — S204

N

Y

Calculate $\eta_{CS\_nom}$ using $P_{R\_NP}$ — S208

Set measured efficiency data as investigating data — S206

Compare $\eta_{NP\_nom}$ with $\eta_{CS\_nom}$ — S210

Is difference below $TH_{\eta\_diff}$? — S212

N

Y

Determine simulated efficiency data using $\eta_{CS\_nom}$ in motor model CM — S214

Determine simulated efficiency data using $\eta_{NP\_nom}$ in motor model CM — S216

Set simulated efficiency data as investigating data — S218

Investigate motor using investigating data — S220

Fig. 7

S300

Set $I_{PRES}$ to $I_{R\_NP}$

Determine $\cos(\varphi_{CS})$ based on $P_{R\_NP}$, $I_{PRES}$ and $\eta_{CS\_nom}$ — S302

S304

Is $\cos(\varphi_{CS})$ above $TH_{PF}$?

Y

S306

Increment $I_{PRES}$

N

S308

Use $\cos(\varphi_{CS})$ together with $\eta_{CS\_nom}$ and $I_{PRES}$ when determining range of simulated efficiency data in motor model CM

Fig. 8

Europäisches
Patentamt

European
Patent Office

Office européen
des brevets

# EUROPEAN SEARCH REPORT

**Application Number**

EP 24 20 0958

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 8 373 379 B2 (SCHNEIDER ELECTRIC USA INC [US]; GAO ZHI [US] ET AL.) 12 February 2013 (2013-02-12) | 1,2, 7-12,14, 15 | INV. G01R31/34 |
| A | * column 5, line 42 - column 5, line 54; claims 1,4; figure 1 * <br> * column 6, line 50 - column 6, line 59 * <br> ----- | 3-6,13 | |
| Y | CN 117 686 221 A (BEIJING BASKA TECH CO LTD) 12 March 2024 (2024-03-12) | 1,2, 7-12,14, 15 | |
| A | * paragraph [0086] - paragraph [0089] * <br> ----- | 3-6,13 | |
| Y | SRITED TERMPONG ET AL: "Induction Motor Efficiency Estimation Using Particle Swarm Optimization with Multiple Operating Conditions", 2022 INTERNATIONAL ELECTRICAL ENGINEERING CONGRESS (IEECON), IEEE, 9 March 2022 (2022-03-09), pages 1-4, XP034107016, DOI: 10.1109/IEECON53204.2022.9741616 | 1,2, 7-12,14, 15 | |
| A | * Page 1, left col. 2nd par. after INTRODUCTION; the whole document * <br> ----- | 3-6,13 | **TECHNICAL FIELDS SEARCHED (IPC)** <br> G01R |
| A | DAUT I ET AL: "The impacts of stator outside diameters on induction motor nameplates: Analysis by using a finite element", RESEARCH AND DEVELOPMENT (SCORED), 2010 IEEE STUDENT CONFERENCE ON, IEEE, 13 December 2010 (2010-12-13), pages 360-365, XP031884872, DOI: 10.1109/SCORED.2010.5704040 ISBN: 978-1-4244-8647-2 * the whole document * <br> ----- <br> -/-- | 1-15 | |

The present search report has been drawn up for all claims

| Place of search | Date of completion of the search | Examiner |
|---|---|---|
| Munich | 20 February 2025 | O'Callaghan, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches Patentamt

European Patent Office

Office européen des brevets

# EUROPEAN SEARCH REPORT

**Application Number**

EP 24 20 0958

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | MAMIZADEH ALI ET AL: "Designing of induction motor efficiency monitoring system without using torque meter and speed sensor", 2017 INTERNATIONAL CONFERENCE ON OPTIMIZATION OF ELECTRICAL AND ELECTRONIC EQUIPMENT (OPTIM) & 2017 INTL AEGEAN CONFERENCE ON ELECTRICAL MACHINES AND POWER ELECTRONICS (ACEMP), IEEE, 25 May 2017 (2017-05-25), pages 330-335, XP033119347, DOI: 10.1109/OPTIM.2017.7974992 [retrieved on 2017-07-11] * the whole document * | 1-15 | |
| A | COLBY R S ET AL: "Measured efficiency of high efficiency and standard induction motors", CONFERENCE RECORD OF THE INDUSTRY APPLICATIONS SOCIETY ANNUAL MEETING. SEATTLE, OCT. 7 - 12, 1990; [CONFERENCE RECORD OF THE INDUSTRY APPLICATIONS SOCIETY ANNUAL MEETING], NEW YORK, IEEE, US, 7 October 1990 (1990-10-07), pages 18-23vol.1, XP032133947, DOI: 10.1109/IAS.1990.152159 ISBN: 978-0-87942-553-1 * the whole document * | 1-15 | TECHNICAL FIELDS SEARCHED (IPC) |

The present search report has been drawn up for all claims

| Place of search | Date of completion of the search | Examiner |
|---|---|---|
| Munich | 20 February 2025 | O'Callaghan, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

&: member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 20 0958

This annex lists the patent family members relating to the patent documents cited in the above-mentioned European search report.
The members are as contained in the European Patent Office EDP file on
The European Patent Office is in no way liable for these particulars which are merely given for the purpose of information.

20-02-2025

| Patent document cited in search report | | Publication date | Patent family member(s) | | Publication date |
|---|---|---|---|---|---|
| US 8373379 | B2 | 12-02-2013 | CA | 2814358 A1 | 26-04-2012 |
| | | | US | 2012098477 A1 | 26-04-2012 |
| | | | WO | 2012054362 A2 | 26-04-2012 |
| CN 117686221 | A | 12-03-2024 | NONE | | |

EPO FORM P0459

For more details about this annex : see Official Journal of the European Patent Office, No. 12/82

**REFERENCES CITED IN THE DESCRIPTION**

**Patent documents cited in the description**

- US 5661386 A